# EUROPEAN PATENT APPLICATION

(11) **EP 2 284 906 A1**
(43) Date of publication of application: **16.02.2011**
(21) Application number: 09750678.6
(22) Date of filing: 19.05.2009
(51) Int. Cl.: H01L 31/04

(54) **MANUFACTURING METHOD OF CIS THIN-FILM SOLAR CELL**

(30) Priority: 20.05.2008 JP 2008132100
(71) Applicant: Showa Shell Sekiyu K.K., 3-2 Daiba 2-chome Minato-ku Tokyo 135-8074 (JP)
(72) Inventor: HAKUMA, Hideki, Tokyo 135-8074 (JP); TANAKA, Yoshiaki, Tokyo 135-8074 (JP); KURIYAGAWA, Satoru, Tokyo 135-8074 (JP)
(74) Representative: HOFFMANN EITLE
(86) International application number: PCT/JP2009/059483
(87) International publication number: WO 2009/142316

(57) **Abstract**

A method of manufacturing a CIS-based thin film solar cell that achieves high photoelectric conversion efficiency comprises: forming a backside electrode layer on a substrate; forming a p-type CIS-based light absorbing layer thereon; and further forming an n-type transparent and electrically conductive film. The above-mentioned forming a p-type CIS-based light absorbing layer comprises: forming a metal precursor film (30a) at least comprising a first metal layer (31, 32) containing a I group element and a second metal layer (33) containing a III group element; and selenizing and/or sulfurizing the metal precursor film, and the above-mentioned forming the metal precursor film includes forming either one of the first metal layer (31, 32) or the second metal layer (33) of at least two layers including a layer (31) that contains an alkali metal and a layer (32) that substantially does not contain the alkali metal.

## Description

### FIELD

The present invention relates to a method for manufacturing a CIS-based thin film solar cell and, in particular, it relates to a method for manufacturing a CIS-based thin film solar cell having high photoelectric conversion efficiency with high reproducibility.

### BACKGROUND

In recent years, a CIS-based thin film solar cell that uses a calcopyrite structure I-III-VI₂ group compound semiconductor containing Cu, In, Ga, Se and S as a p-type light absorbing layer has been attracting attention. Since a solar cell of this type can be manufactured at relatively low cost and it is expected to achieve high photoelectric conversion efficiency, it is considered to be a leading candidate for a next-generation solar cell. Typical materials include Cu(In, Ga)Se₂, Cu(In, Ga) (Se, S)₂, CuInS₂, etc..

In a CIS-based thin film solar cell, a metal backside electrode layer is formed on a glass substrate. Then, a p-type light absorbing layer comprised of the I-III-VI₂ group compound semiconductor is formed thereon and, further, an n-type high resistance buffer layer and an n-type transparent and electrically conductive window layer are formed. In this CIS-based thin film solar cell, it is reported that high photoelectric conversion efficiency can be achieved when soda lime glass is used as the glass substrate. It is thought that this is because Na, or an Ia group element contained in soda lime glass is diffused into the p-type light absorbing layer in the formation process of this layer and affects carrier concentration. Therefore, in a CIS-based thin film solar cell, it has long been appreciated that controlling of introduction of Na into the p-type light absorbing layer is an important task to improve its photoelectric conversion efficiency.

Controlling the introduction of Na into the p-type light absorbing layer are broadly divided into two categories. The first one is based on fact that Na contained in the soda lime glass substrate is diffused and absorbed into the p-type light absorbing layer in the formation process of the CIS-based p-type light absorbing layer and controls the amount of diffusion. (See Patent Literature 1.) The second one adds a Na compound from the outside in the formation process of the p-type light absorbing layer. In this case, after inhibiting the diffusion of Na from the glass substrate by providing a blocking layer between the glass substrate and the p-type light absorbing layer, or securing that Na is not diffused from the substrate by using the glass substrate that does not contain Na, the Na compound is added to the p-type light absorbing layer. By doing so, the Na concentration in the p-type light absorbing layer is controlled. (See Patent Literatures 2 and 3 and Non-patent Literature 1.)

The first approach described above is predicated on the basis that soda lime glass is used as the glass substrate. However, soda lime glass has a problem in that it has a relatively low distortion point and deforms if the p-type light absorbing layer is formed at a high temperature, for example, at 550 °C or more to improve photoelectric conversion efficiency and, therefore, the formation temperature cannot be increased. In order to perform the formation process at such a high temperature, a low alkali glass, such as high distortion point glass or non-alkali glass, has to be used as the glass substrate. However, such glass contains little or no alkali component and cannot supply the sufficient alkali component to the p-type light absorbing layer.

The second approach does not need to use the soda lime glass and, therefore, it can solve the problem of the first approach described above. However, in this approach, it is difficult to add the alkali element to the p-type light absorbing layer uniformly and with good reproducibility. It is difficult to treat the alkali metal element such as Na and, in order to add the alkali element to the p-type light absorbing layer, a stable compound such as NaF has to be added by spraying or mixed into the Se material. Efficiency of such addition is poor and, in the case of NaF, F may adversely affect the formation of the p-type light absorbing layer. Further, when NaF is added to the p-type light absorbing layer by spraying and the like, there are problems in that diameters of the added particles are not uniform and the uniform spraying is difficult.

### CITATION LIST

### PATENT References

Reference 1: Japanese Unexamined Patent Publication No. H10-74968
Reference 2: Japanese Unexamined Patent Publication No. H8-222750
Reference 3: Japanese Unexamined Patent Publication No. H8-102546

### NON-PATENT References

Non-patent Reference 1: "The effect of substructure impurities on the electronic conductivity in CIS thin films", 12th European photovoltaic solar energy conference, J. Holz, F. Karg, H. von Philipsborn

### SUMMARY OF THE INVENTION

### TECHNICAL PROBLEM

The present invention has been made to solve the above problems and it is an object of the present invention to provide a method for manufacturing a CIS-based thin film solar cell that can add an alkali element to a p-type light absorbing layer without using a soda lime glass and, moreover, easily and with high controllability, so as to achieve high photoelectric conversion efficiency.

### SOLUTION TO PROBLEM

In order to solve the above object, in an aspect of the present invention, there is provided a method for manufacturing a CIS-based thin film solar cell comprising: forming a backside electrode layer on a substrate; forming a p-type CIS-based light absorbing layer on the backside electrode layer; and forming an n-type transparent and electrically conductive film on the p-type CIS-based light absorbing layer, wherein said forming the p-type CIS-based light absorbing layer comprises: forming a metal precursor film at least comprising a first metal layer containing a I group element and a second metal layer containing a III group element; and selenizing and/or sulfurizing the metal precursor film, and wherein said forming the metal precursor film includes forming either one of said first metal layer or second metal layer of at least two layers including a layer that contains an alkali metal and a layer that substantially does not contain the alkali metal.

In the method, the first metal layer and the second metal layer may be formed by sputtering, vapor deposition or ion plating.

Further, the substrate may be formed of high distortion point glass, non-alkali glass, metal or resin.

Further, the first metal layer may be formed of Cu or CuGa alloy and the second metal layer may be formed of In.

Further, the alkali metal may be Na, K or Li.

Further, when the first metal layer is a CuGa alloy layer, the layer that contains the alkali metal may be formed by using CuGa that contains at least 0.5 at.% (a ratio of the number of atoms, atomic percent) of Na as a target or a deposition source.

Further, a Ga concentration in the CuGa target may be 25 at.%.

Further, the layer that substantially does not contain the alkali metal may be formed by using CuGa that contains 100 at.ppm (atomic ppm) or less of Na as a target or a deposition source.

Further, a step of forming an n-type high resistance buffer layer may be provided between the step of forming the p-type light absorbing layer and the step of forming the n-type transparent and electrically conductive film.

Further, when the first metal layer is an In layer, the layer that contains the alkali metal may be formed by using In that contains at least 0.2 at.% of Na as a target or a deposition source.

At this time, the layer that substantially does not contain the alkali metal may be formed by using In that contains 100 at.ppm or less of Na as a target or a deposition source.

### ADVANTAGEOUS EFFECTS OF THE INVENTION

In the method of the present invention, the metal precursor film for forming the p-type light absorbing layer contains the alkali element. Consequently, during the selenization/sulfurization of the metal precursor film, the alkali element is diffused so that the p-type light absorbing layer having a certain alkali concentration is formed. As a result, there is no need to use soda lime glass containing the alkali element as the substrate for forming the solar cell and the substrate that can withstand high temperature heating can be used to increase the temperature when the p-type light absorbing layer is formed. Further, because the alkali element is added to the electrode material not in the form of compound but in the form of metal, efficiency of the addition is improved. Still further, the metal precursor film is formed, for example, by the sputtering, vapor deposition or ion plating using a film material to which the alkali metal is added as the target or deposition source, so that the alkali metal can be added to the metal precursor film uniformly and, moreover, with good reproducibility. As a result, a CIS-based thin film solar cell of high quality can be manufactured with low cost.

### BRIEF DESCRIPTION OF THE DRAWING

Fig. 1 is a schematic cross-sectional view of a CIS-based thin film solar cell that is manufactured by a method according to an embodiment of the present invention;
Figs. 2A - 2F are schematic cross-sectional views for describing structures of a metal precursor film when Na is added to a CuGa target;
Figs. 3A - 3F are schematic cross-sectional views describing structures of a metal precursor film when Na is added to an In target;
Figs. 4A - 4F are schematic cross-sectional views describing structures of a metal precursor film when Na is added to a Cu target;
Fig. 5 is a diagram describing a process for forming a metal precursor film; and
Fig. 6 is a diagram illustrating a schematic configuration of a reactor used for selenization/sulfurization.

### DESCRIPTION OF THE EMBODIMENTS

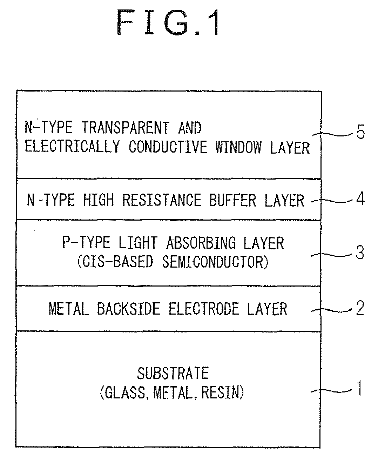

Fig. 1 is a schematic cross-sectional view illustrating a structure of a CIS-based thin film solar cell manufactured by a method according to an embodiment of the present invention. In this figure, a glass substrate 1 is comprised of low alkali glass such as high distortion point glass or non-alkali glass. Since such glass substrate has a distortion point 50 °C or more higher than that of conventional soda lime glass, in a process for forming a p-type light absorbing layer, process temperature can be increased and, as a result, a high-quality p-type light absorbing layer can be formed. Substrate 1 may be comprised of materials other than glass, such as stainless steel or other metals, polyimide resin and the like.

In Fig. 1, a metal backside electrode layer 2 is illustrated. Metal backside electrode layer 2 has a thickness of 0.2 - 2 µm and it is formed of high corrosion resistant and high melting point metals such as molybdenum (Mo), titanium (Ti), chromium (Cr) or the like.

In Fig. 1, a p-type CIS-based light absorbing layer (hereinafter referred to as the "p-type light absorbing layer") 3 is a I-III-VI₂ group calcopyrite structure thin film of 1 - 3 µm thickness and a multinary compound semiconductor thin film such as, for example, CuInSe₂, Cu(InGa)Se₂, Cu(InGa) (SSe)₂ is used for this layer. P-type light absorbing layer 3 is typically formed by selenization/sulfurization or multi-source simultaneous deposition. The present invention adopts the selenization/sulfurization. In the selenization/sulfurization, a metal precursor film of laminated or mixed-crystal structure containing copper (Cu), indium (In) and gallium (Ga) (Cu/In, Cu/Ga, Cu-Ga alloy/In, Cu-Ga-In alloy and the like) is deposited on metal backside electrode layer 2 by sputtering, vapor deposition or ion plating and, then, heat treatment is performed at about 400 °C or more in selenium and/or sulfur-containing atmosphere, so that p-type light absorbing layer 3 can be formed.

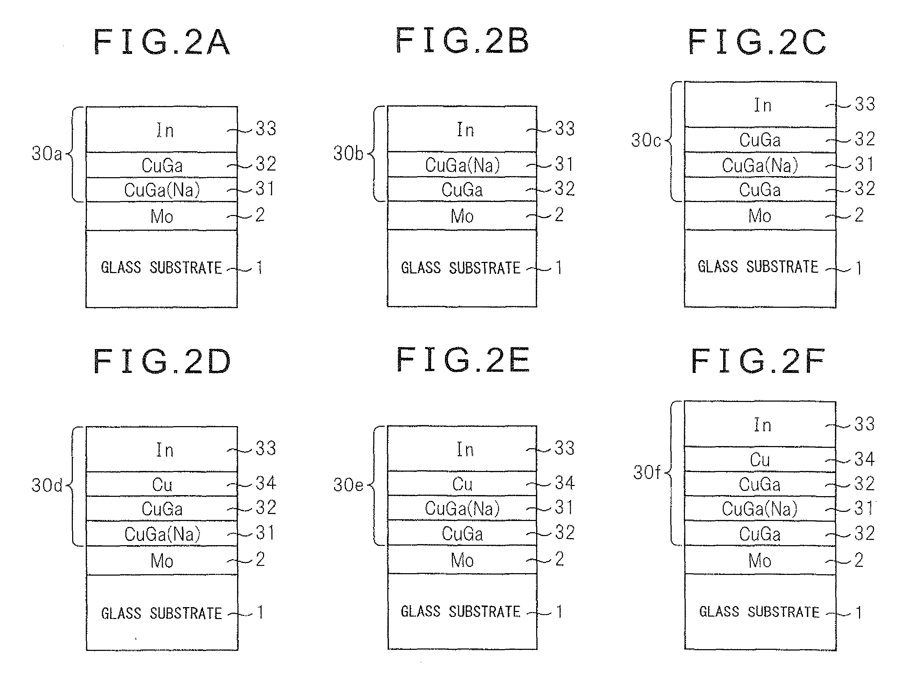

In the present invention, when this metal precursor film is formed, an alkali metal such as Na is added to a sputtering target or a deposition source, so that a certain amount of the alkali metal is contained in the metal precursor film formed on the substrate. This alkali metal is diffused across p-type light absorbing layer 3 by the heat treatment in the selenization/sulfurization process, so that a certain concentration of the alkali element is contained in p-type light absorbing layer 3. A manufacturing process of the metal precursor film that contains the alkali metal will be described below with reference to Figs. 2A and so on.

In Fig. 1, an n-type high resistance buffer layer 4 is formed on p-type light absorbing layer 3. n-type high resistance buffer layer 4 is an ultra thin film of 10-50 nm film thickness that has n-type conductivity and wide band gap and that is transparent and high resistant. n-type high resistance buffer layer 4 is comprised of a compound containing Cd, Zn and In, such as, typically, CdS, ZnO, ZnS, Zn(OH)₂, In₂O₃, In₂S₃, or their mixed crystal Zn(O, S, OH). n-type high resistance buffer layer 4 is typically deposited by chemical bath deposition (CBD) but it may be formed by a dry process such as metal organic chemical vapor deposition (MOCVD) and atomic layer deposition (ALD). In the CBD process, the substrate is immersed in a solution containing chemical species acting as precursors to cause heterogeneous reaction between the solution and the substrate surface, so that the thin film can be deposited on the substrate.

In Fig. 1, an n-type transparent and electrically conductive window layer 5 is a transparent and electrically conductive film of 0.05 - 2.5 µm film thickness that has n-type conductivity and wide band gap and that is transparent and low resistant. Window layer 5 is typically comprised of a zinc oxide (ZnO) based thin film or an ITO thin film. In the case of the ZnO film, it is made low resistant by adding a III group element (for example, Al, Ga and B) as a dopant. n-type transparent and electrically conductive window layer 5 is formed by sputtering (DC, RF), MOCVD and the like.

Fig. 2A - 2F are diagrams for describing a manufacturing process of p-type light absorbing layer 3 illustrated in Fig. 1 that, in particular, describe a manufacturing method of metal precursor films 30a - 30f. The embodiments illustrated in Figs. 2A - 2F illustrate cases in which Mo is used as the metal that forms metal backside electrode layer 2 and, when the metal precursor film is formed, Na is used as the alkali metal that is added to a CuGa target. However, the present invention is not limited to these materials. For example, Ti, Cr and the like may be used for the metal backside electrode in place of Mo. On the other hand, K, Li and the like may be used as the alkali metal added to the sputtering target in place of Na.

The embodiments in Figs. 2A - 2C illustrate processes for forming CuGa-In metal precursor films 30a - 30c. In the embodiment illustrated in Fig. 2A, Mo is sputtered on substrate 1 made of non-alkali or low alkali glass to form metal backside electrode 2. Next, sputtering is performed by using the CuGa target containing a certain amount of the alkali metal such as, for example, Na metal, to form a CuGa alloy layer 31 that contains alkali metal such as Na on metal backside electrode 2. Then, sputtering is performed by using the CuGa target that substantially does not contain the alkali metal to form a CuGa layer 32 that substantially does not contain the alkali metal on CuGa layer 31 that contains the alkali metal. After that, an In layer 33 is formed by sputtering using an In target.

The "CuGa target that substantially does not contain the alkali metal such as Na" means that the alkali metal is not positively added to the target material. However, in reality, it contains the alkali metal of very low concentration such as, for example, 1 - 100 at.ppm. However, such low concentration of the alkali metal affects the p-type light absorbing layer very little and, therefore, it is mentioned as "the target or layer that substantially does not contain the alkali metal" in this patent specification.

In the embodiment illustrated in Fig. 2B, first, CuGa layer 32 that does not contain Na is formed on Mo backside electrode 2. Then, CuGa layer 31 that contains Na is formed and, then, In layer 33 is formed to form metal precursor film 30b. In the embodiment illustrated in Fig. 2C, Mo metal backside electrode layer 2 is formed on glass substrate 1 and, then, CuGa layer 32 is formed by using the CuGa target that does not contain Na. Then, CuGa layer 31 that contains Na is formed by using the CuGa target that contains Na and, further, CuGa layer 32 is formed by using the CuGa target that does not contain Na. Then, In layer 33 is formed by sputtering the In target to form metal precursor film 30c.

Figs. 2D - 2F illustrate processes for forming CuGa-Cu-In metal precursor films 30d- 30f. In the embodiment illustrated in Fig. 2D, CuGa layer 31 that contains Na is formed on metal backside electrode 2 and, then, CuGa layer 32 that does not contain Na is formed. Then, a Cu layer 34 is formed on layer 32 by using a Cu target and, then In layer 33 is formed. As a result, metal precursor film 30d that contains Na is formed.

In the embodiment illustrated in Fig. 2E, first, CuGa layer 32 that does not contain Na is formed on metal backside electrode 2 and, then, CuGa layer 31 that contains Na is formed. After that, similarly to the embodiment illustrated in Fig. 2D, Cu layer 34 and In layer 33 are formed. In the embodiment illustrated in Fig. 2F, CuGa layer 32 that does not contain Na is further formed between CuGa layer 31 that contains Na and Cu layer 34 of the example illustrated in Fig. 2E. In Fig. 2A - 2F, a Ga concentration in the CuGa target is in the range of 10 - 50% and it is substantially constant. Therefore, the Ga concentration can be maintained constant even when the Na amount is changed.

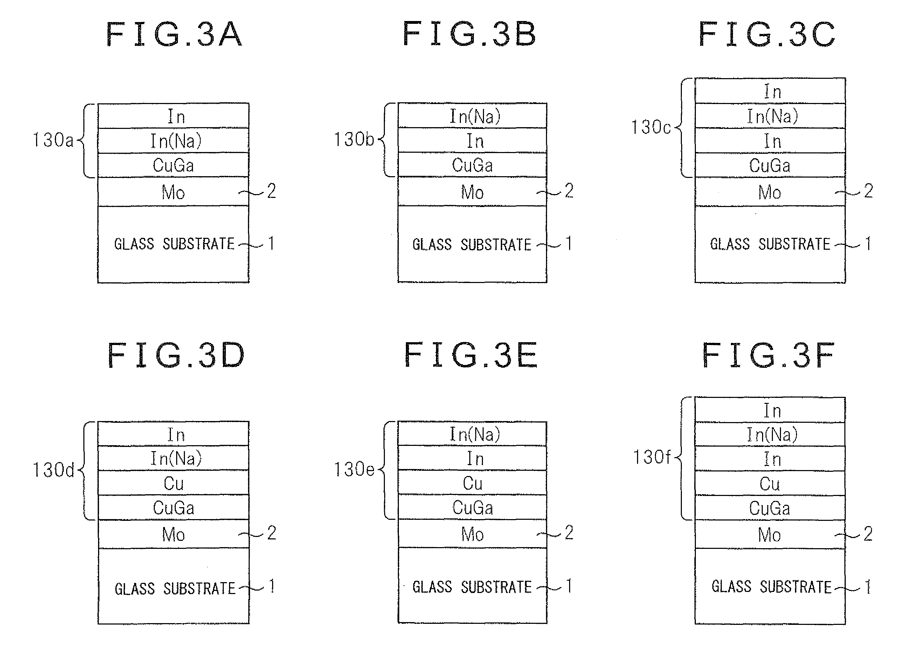

Figs. 3A - 3F illustrate examples in which metal precursor films 130a - 130f that contain Na are formed by adding Na to the In target. In the example illustrated in Fig. 3A, three sputtering targets of CuGa, In that contains Na, and In that does not contain Na are used. The sputtering is performed in this order to form metal precursor film 130a that contains Na. In the example illustrated in Fig. 3B, sputtering targets of CuGa, In, and In that contains Na are used and the sputtering is performed in this order to form metal precursor film 130b that contains Na. In the example illustrated in Fig. 3C, sputtering targets of CuGa, first In, In that contains Na, and second In are used and the sputtering is performed in this order to form metal precursor film 130c that contains Na.

In the example illustrated in Fig. 3D, sputtering targets of CuGa, Cu, In that contains Na, and In that does not contain Na are used and the sputtering is performed in this order to form metal precursor film 130d that contains Na. In the example illustrated in Fig. 3E, sputtering targets of CuGa, Cu, In that does not contain Na, and In that contains Na are used and the sputtering is performed in this order to form metal precursor film 130e that contains Na. In the example illustrated in Fig. 3F, sputtering targets of CuGa, Cu, In that does not contain Na, In that contains Na, and In that does not contain Na are used and the sputtering is performed in this order to form metal precursor film 130f that contains Na.

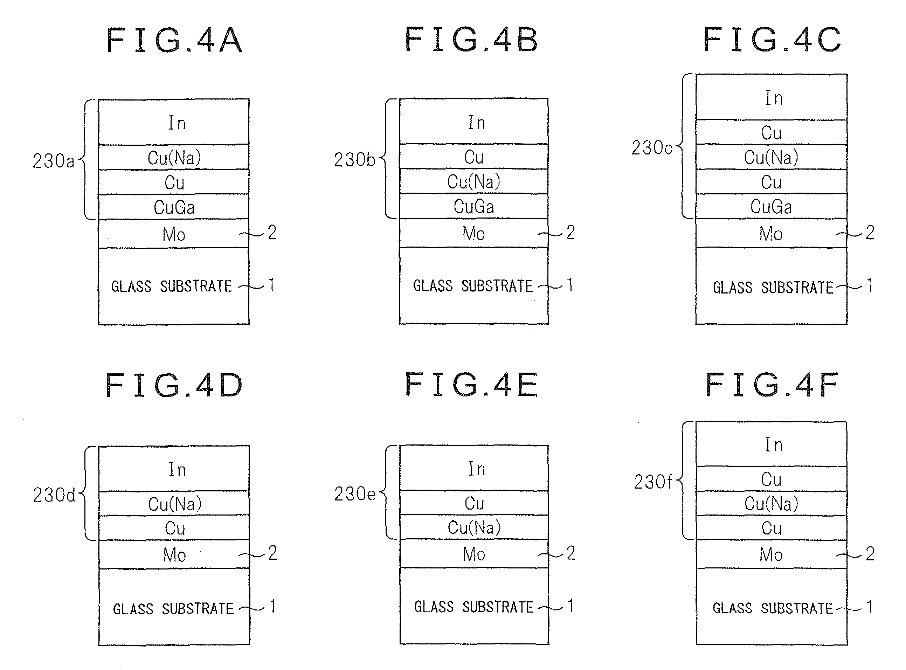

Figs. 4A - 4F illustrate examples in which metal precursor films 230a - 230f that contain Na are formed by adding Na to the Cu target. In the example illustrated in Fig. 4A, sputtering targets of CuGa, Cu, Cu that contains Na, and In are used and the sputtering is performed in this order to form metal precursor film 230a that contains Na. In the example illustrated in Fig. 4B, sputtering targets of CuGa, Cu that contains Na, Cu that does not contain Na, and In are used and the sputtering is performed in this order to form metal precursor film 230b that contains Na. In the example illustrated in Fig. 4C, sputtering targets of CuGa, Cu, Cu that contains Na, Cu that does not contain Na, and In are used and the sputtering is performed in this order to form metal precursor film 230c that contains Na.

In the example illustrated in Fig. 4D, sputtering targets of Cu that does not contain Na, Cu that contains Na, and In are used and the sputtering is performed in this order to form Cu-In alloy metal precursor film 230d that contains Na. In the example illustrated in Fig. 4E, sputtering targets of Cu that contains Na, Cu that does not contain Na, and In are used and the sputtering is performed in this order to form metal precursor film 230e that contains Na. In the example illustrated in Fig. 4F, sputtering targets of Cu that does not contain Na, Cu that contains Na, and Cu and In, both of which do not contain Na, are used and the sputtering is performed in this order to form metal precursor film 230f that contains Na.

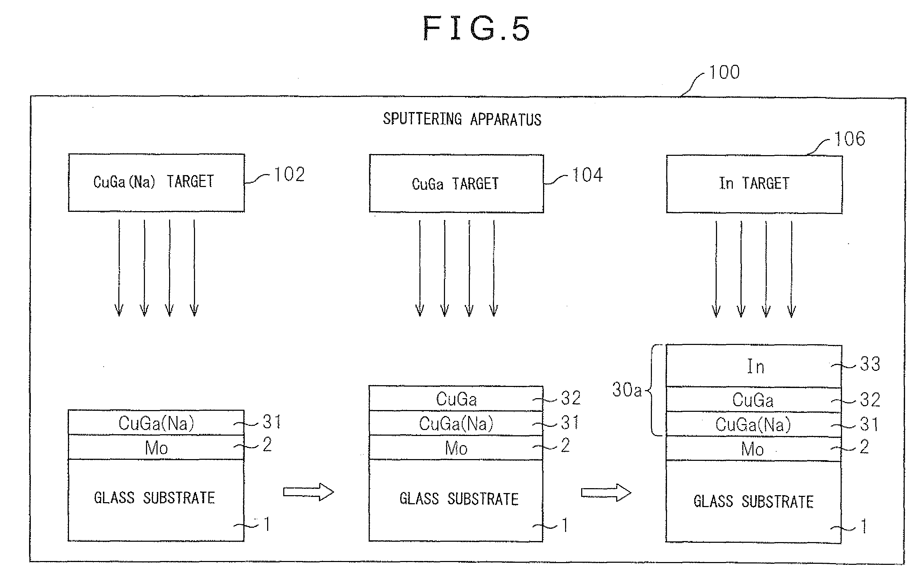

Fig. 5 is a diagram illustrating a process for forming metal precursor film 30a of the structure illustrated in Fig. 2A. In the figure, there is illustrated a sputtering apparatus 100 in which a plurality of targets 102, 104 and 106 are provided. Target 102 is comprised of CuGa that contains Na. Target 104 is comprised of CuGa that does not contain Na. Target 106 is comprised of In. Glass substrate 1 on which Mo metal backside electrode layer 2 is formed is sequentially moved to positions of each target. First, glass substrate 1 is sputtered with CuGa that contains Na under target 102 so that CuGa layer 31 that contains Na is formed on Mo layer 2. Next, glass substrate 1 is transferred to the position under target 104 and sputtered with CuGa that does not contain Na so that CuGa layer 32 that does not contain Na is formed on CuGa layer 31 that contains Na. After that, glass substrate 1 is transferred to the position under target 106 and sputtered with In so that In layer 33 is formed on CuGa layer 32 that does not contain Na.

After CuGa-In metal precursor film 30a that contains Na is formed on metal backside electrode 2 as described above, this substrate undergoes the selenization/sulfurization process and, as a result, it is converted into P-type light absorbing layer 3.

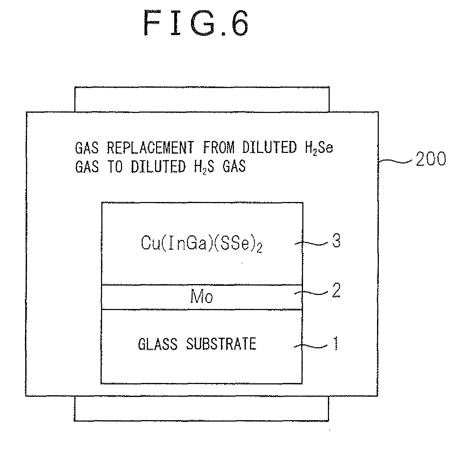

Fig. 6 illustrates a reactor 200 for performing the selenization/sulfurization process. Glass substrate 1 on which, for example, CuGa-In metal precursor film 30a that contains Na is formed is accommodated in reactor 200. While maintaining temperature at about 400 °C, the reactor is filled with diluted H₂Se gas and, then, the diluted H₂Se gas is replaced by diluted H₂S gas to form p-type Cu (InGa) (SSe) ₂. At this time, Na that is contained in metal precursor film 30a is diffused across p-type light absorbing layer 3 by the heat treatment.

Though the sputtering is used for forming metal precursor film 30a in the embodiment illustrated in Fig. 5, the present invention is not limited to the sputtering and vapor deposition or ion plating may be used. Also in such cases, both the film materials to which Na metal is added and the film materials to which Na metal is not positively added are used as the target or vapor deposition source to form the metal precursor film in multi-stages.

As described above, because the addition of Na to the metal precursor film is performed using the materials of the metal precursor film to which the metallic Na is added as the target or deposition source, in comparison with the case in which Na is added as a compound such as NaF, efficiency of the addition is improved and, further, because the metal precursor film does not contain elements other than Na, it does not occur that the absorbed elements other than Na adversely affect the p-type light absorbing layer. Further, because the metal precursor film is formed not by the spraying but by the sputtering, vapor deposition or ion plating, the p-type light absorbing layer that uniformly contains the alkali metal of a desired concentration can be formed easily.

Still further, because the metal precursor film is formed by the sputtering, vapor deposition or ion plating performed in at least two stages with the combination of the target materials that contain a certain amount of Na and the target materials that substantially do not contain Na, the amount of Na to be added to p-type light absorbing layer 3 can be controlled freely.

Hereinafter, Experimental Examples 1 and 2 in which the CIS-based thin film solar cell was manufactured according to the method of the present invention as well as the effects of the present invention will be described. In the both experimental examples, the CIS-based thin film solar cell was manufactured on process conditions stated in Table 1.

**Table 1: Process conditions**

| | |
|---|---|
| Glass substrate 1 | High distortion point glass (PD200, manufactured by Asahi Glass Co., Ltd.) |
| Metal backside electrode layer 2 | Sputtering by using a Mo target. Film thickness - 0.5 µm. |
| P-type light absorbing layer 3 | After forming a metal precursor film, Cu (InGa) (SSe)₂ is formed by selenization/sulfurization. |
| | Film thickness - 1.5µm |
| | Cu/III = 0.9, Ga/III = 0.3 |
| | Selenization = 400 °C x 30 min., |
| | volume concentration of H₂Se - 5% sulfurization = 550 °C x 70 min., |
| | volume concentration of H₂S - 15% Na concentration when the metal precursor film is formed is stated separately. |
| N-type high resistance | CBD |
| buffer layer 4 | Zn (O, S, OH) |
| | Film thickness - 30 nm |
| N-type transparent and | MOCVD |
| electrically | ZnO:B |
| conductive window layer | Film thickness - 1.3 µm |

The concentration of Na in the CuGa target is stated in Table 2.

**Table 2: Na concentration in CuGa target**

| | |
|---|---|
| High Na target | 0.1 at.%, 0.3 at.%, 1 at. %, 3 at.% |
| Low Na target (without Na) | 1 at.ppm, 10 at.ppm, 100 at.ppm |
| Ga concentration | 25 at.% in both targets |

### [Experimental Example 1]

In the CIS-based thin film solar cell used in this experiment, metal precursor film 30b of the structure illustrated in Fig. 2B was formed. Thus, after forming Mo metal backside electrode 2 on glass substrate 1, CuGa layer 32 with low Na concentration, CuGa layer 31 with high Na concentration, and In layer 33 were formed by the sputtering. Then, the selenization/sulfurization was performed according to the process conditions of Table 1 to form p-type light absorbing layer 3 of Cu (InGa) (SSe)₂. Then, n-type high resistance buffer layer 4 and n-type transparent and electrically conductive window layer 5 were further formed according to the process conditions of Table 1 to constitute the CIS-based thin film solar cell. On conditions that the Na concentration in the low Na target was fixed to 10 at.ppm and the Na concentration in the high Na target was set to the four levels stated in Table 2, a film thickness ratio between CuGa layer 31 with high Na concentration and CuGa layer 32 with low Na concentration was changed. The experimental results of this case are illustrated in Table 3.

**Table 3: Experimental results 1**

| High Na concentration [at.%] | Low Na film thickness ratio | High Na film thickness ratio | Conversion efficiency [%] | Average Na concentration in CIS [at.%] |
|---|---|---|---|---|
| 0.3 | 0 | 1 | 13.7 | 0.07 |
| 0.3 | 0.2 | 0.8 | 12.0 | 0.06 |
| 0.3 | 0.4 | 0.6 | 11.2 | 0.04 |
| 0.3 | 0.6 | 0.4 | 10.2 | 0.03 |
| 0.3 | 0.8 | 0.2 | 8.6 | 0.01 |
| 0.5 | 0 | 1 | 15.0 | 0.12 |
| 0.5 | 0.2 | 0.8 | 15.9 | 0.10 |
| 0.5 | 0.4 | 0.6 | 14.3 | 0.07 |
| 0.5 | 0.6 | 0.4 | 12.6 | 0.04 |
| 0.5 | 0.8 | 0.2 | 10.5 | 0.02 |
| 1 | 0 | 1 | 14.5 | 0.23 |
| 1 | 0.2 | 0.8 | 15.7 | 0.19 |
| 1 | 0.4 | 0.6 | 15.7 | 0.14 |
| 1 | 0.5 | 0.4 | 15.2 | 0.09 |
| 1 | 0.8 | 0.2 | 13.7 | 0.05 |
| 3 | 0 | 1 | detachment | - |
| 3 | 0.2 | 0.8 | detachment | - |
| 3 | 0.4 | 0.6 | 4.3 | 0.43 |
| 3 | 0.6 | 0.4 | 14.1 | 0.28 |
| 3 | 0.8 | 0.2 | 15.4 | 0.15 |
| - | 1 | 0 | 5.5 | 0.00 |

As apparent from Table 3, the CIS-based thin film solar cell having high photoelectric conversion efficiency of 14% or more could be obtained by controlling the Na concentration in the CuGa target. On the other hand, high photoelectric conversion efficiency could be obtained in some conditions even though only CuGa layer 31 with high Na concentration was formed and CuGa layer 32 with low Na concentration was not formed (the cases in which the Na concentration in the high Na target was 0.5 at.% and 1 at.%). However, in these cases, it is technically rather difficult to control the amount of Na in the target with good reproducibility and, as a result, product yields are reduced and manufacturing cost increases. Therefore, it is preferred that the CuGa layer in the metal precursor film is formed of at least two layers including the CuGa layer with high Na concentration and the CuGa layer with low Na concentration (without Na). Further, from the photoelectric conversion efficiency column in Table 3, it is found that the desired Na concentration in the CuGa target with high Na concentration is 0.5 at.% or more. Further, because the Ga concentration in the CuGa target is maintained constant (25 at.%), the Ga concentration does not vary even when the film thickness is changed.

### [Experimental Example 2]

The CIS-based thin film solar cell used in this experiment had a structure similar to that in Experimental Example 1 and it was manufactured in the same manufacturing process. Thus, after forming Mo metal backside electrode 2 on glass substrate 1, CuGa layer 32 with low Na concentration, CuGa layer 31 with high Na concentration, and In layer 33 were formed by the sputtering. (See Fig. 2B.) Then, the selenization/sulfurization was performed according to the process conditions of Table 1 to form p-type light absorbing layer 3 of Cu(InGa) (SSe)₂. Then, n-type high resistance buffer layer 4 and n-type transparent and electrically conductive window layer 5 were further formed according to the process conditions of Table 1 and its photoelectric conversion efficiency was measured.

In Experimental Example 2, on conditions that the Na concentration in the low Na target was set to the three levels stated in Table 2 and the Na concentration in the high Na target was fixed to 1 at.%, the film thickness ratio between the CuGa layer with low Na concentration and the CuGa layer with high Na concentration was changed. The experimental results of this case are illustrated in Table 4.

**Table 4: Experimental results 2**

| Low Na concentration [at.ppm] | Low Na film thickness ratio | High Na film thickness ratio | Conversion efficiency [%] | Average Na concentration in CIS [at.%] |
|---|---|---|---|---|
| 1 | 0 | 1 | 14.5 | 0.23 |
| 1 | 0.2 | 0.8 | 15.5 | 0.19 |
| 1 | 0.4 | 0.6 | 15.7 | 0.15 |
| 1 | 0.6 | 0.4 | 15.0 | 0.09 |
| 1 | 0.8 | 0.2 | 13.6 | 0.05 |
| 10 | 0.2 | 0.8 | 15.7 | 0.19 |
| 10 | 0.4 | 0.6 | 15.7 | 0.14 |
| 10 | 0.6 | 0.4 | 15.2 | 0.09 |
| 10 | 0.8 | 0.2 | 13.7 | 0.05 |
| 100 | 0.2 | 0.8 | 15.9 | 0.20 |
| 100 | 0.4 | 0.6 | 15.4 | 0.15 |
| 100 | 0.6 | 0.4 | 15.5 | 0.10 |
| 100 | 0.8 | 0.2 | 13.5 | 0.05 |
| - | 1 | 0 | 5.5 | 0.00 |

As apparent from Table 4, the CIS based thin film solar cell having high photoelectric conversion efficiency of 14% or more could be formed by controlling the film thickness of the CuGa layer with low Na concentration and the film thickness of the CuGa layer with high Na concentration. The Na concentration in the CuGa target with low Na concentration was constant at 1 - 100 at.ppm (0.01 at.%). Therefore, the Na concentration in the target with low Na concentration should be 100 at.ppm or less.

Hereinafter, Experimental Examples 3 and 4 in which the CIS-based thin film solar cell is manufactured according to the method of the present invention as well as the effects of the present invention will be described. In the both experimental examples, the CIS-based thin film solar cell was manufactured on process conditions stated in Table 1. Experimental Examples 3 and 4 differed from Experimental Examples 1 and 2 in that Na was added to the In target to form the p-type light absorbing layer.

The concentration of Na in the In target is stated in Table 5.

**Table 5: Na concentration in In target**

| | |
|---|---|
| High Na target | 0.1 at.%, 0.2 at.%, 0.5 at.%, 1.5 at.% |
| Low Na target (without Na) | 1 at.ppm, 10 at.ppm, 100 at.ppm |

### [Experimental Example 3]

In the CIS-based thin film solar cell used in this experiment, metal precursor film 130a of the structure illustrated in Fig. 3A was formed. Thus, after forming Mo metal backside electrode 2 on glass substrate 1, the CuGa layer, the In layer with high Na concentration, and the In layer with low Na concentration were formed by the sputtering. Then, the selenization/sulfurization was performed according to the process conditions of Table 1 to form p-type light absorbing layer 3 of Cu(InGa)(SSe)₂. Then, n-type high resistance buffer layer 4 and n-type transparent and electrically conductive window layer 5 were further formed according to the process conditions of Table 1 to constitute the CIS-based thin film solar cell. On conditions that the Na concentration in the low Na target was fixed to 10 at.ppm and the Na concentration in the high Na target was set to the four levels stated in Table 5, a film thickness ratio between the In layer with high Na concentration and the In layer with low Na concentration was changed. The experimental results of this case are illustrated in Table 6.

**Table 3: Experimental results 3**

| High Na concentration [at.%] | Low Na film thickness ratio | High Na film thickness ratio | Conversion efficiency [%] | Average Na concentration in CIS [at.%] |
|---|---|---|---|---|
| 0.1 | 0 | 1 | 12.8 | 0.05 |
| 0.1 | 0.2 | 0.8 | 11.2 | 0.04 |
| 0.1 | 0.4 | 0.6 | 10.6 | 0.03 |
| 0.1 | 0.6 | 0.4 | 9.9 | 0.02 |
| 0.1 | 0.8 | 0.2 | 8.3 | 0.01 |
| 0.2 | 0 | 1 | 15.5 | 0.09 |
| 0.2 | 0.2 | 0.8 | 15.2 | 0.07 |
| 0.2 | 0.4 | 0.6 | 13.9 | 0.05 |
| 0.2 | 0.6 | 0.4 | 12.0 | 0.03 |
| 0.2 | 0.8 | 0.2 | 10.6 | 0.02 |
| 0.5 | 0 | 1 | 14.8 | 0.24 |
| 0.5 | 0.2 | 0.8 | 15.5 | 0.18 |
| 0.5 | 0.4 | 0.6 | 15.7 | 0.13 |
| 0.5 | 0.6 | 0.4 | 15.4 | 0.09 |
| 0.5 | 0.8 | 0.2 | 13.6 | 0.04 |
| 2 | 0 | 1 | detachment | - |
| 2 | 0.2 | 0.8 | detachment | - |
| 2 | 0.4 | 0.6 | detachment | - |
| 2 | 0.6 | 0.4 | 3.8 | 0.38 |
| 2 | 0.8 | 0.2 | 15.0 | 0.18 |
| - | 1 | 0 | 6.6 | 0.00 |

As apparent from Table 6, the CIS-based thin film solar cell having high photoelectric conversion efficiency of 14% or more could be obtained by controlling the Na concentration in the In target. On the other hand, high photoelectric conversion efficiency could be obtained in some conditions even though only the In layer with high Na concentration was formed and the In layer with low Na concentration was not formed (the cases in which the Na concentration in the high Na target was 0.2 at.% and 0.5 at.%). However, in these cases, it is technically rather difficult to control the amount of Na in the target with good reproducibility and, as a result, product yields are reduced and manufacturing cost increases. Therefore, it is preferred that the In layer in the metal precursor film is formed of at least two layers including the In layer with high Na concentration and the In layer with low Na concentration (without Na). Further, from the photoelectric conversion efficiency column in Table 6, it is found that the desired Na concentration in the In target with high Na concentration is 0.2 at.% or more.

### [Experimental Example 4]

The CIS-based thin film solar cell used in this experiment had a structure similar to that in Experimental Example 3 and it was manufactured in the same manufacturing process. Thus, after forming Mo metal backside electrode 2 on glass substrate 1, the CuGa layer, the In layer with high Na concentration, and the In layer with low Na concentration were formed by the sputtering. (See Fig. 3A.) Then, the selenization/sulfurization was performed according to the process conditions of Table 1 to form p-type light absorbing layer 3 of Cu(InGa)(SSe)₂. Then, n-type high resistance buffer layer 4 and n-type transparent and electrically conductive window layer 5 were further formed according to the process conditions of Table 1 and its photoelectric conversion efficiency was measured.

In Experimental Example 4, on conditions that the Na concentration in the low Na target was set to the three levels stated in Table 5 and the Na concentration in the high Na target was fixed to 0.5 at.%, the film thickness ratio between the In layer with low Na concentration and the In layer with high Na concentration was changed. The experimental results of this case are illustrated in Table 7.

**Table 7: Experimental results 4**

| Low Na concentration [at.ppm] | Low Na film thickness ratio | High Na film thickness ratio | Conversion efficiency [%] | Average Na concentration in CIS [at.%] |
|---|---|---|---|---|
| 1 | 0 | 1 | 14.8 | 0.24 |
| 1 | 0.2 | 0.8 | 15.7 | 0.18 |
| 1 | 0.4 | 0.6 | 15.7. | 0.14 |
| 1 | 0.6 | 0.4 | 15.2 | 0.09 |
| 1 | 0.8 | 0.2 | 13.7 | 0.04 |
| 10 | 0.2 | 0.8 | 15.4 | 0.19 |
| 10 | 0.4 | 0.6 | 15.9 | 0.13 |
| 10 | 0.6 | 0.4 | 15.4 | 0.08 |
| 10 | 0.8 | 0.2 | 13.4 | 0.04 |
| 100 | 0.2 | 0.8 | 15.4 | 0.19 |
| 100 | 0.4 | 0.6 | 15.7 | 0.14 |
| 100 | 0.6 | 0.4 | 15.5 | 0.08 |
| 100 | 0.8 | 0.2 | 13.7 | 0.04 |
| - | 1 | 0 | 6.6 | 0.00 |

As apparent from Table 7, the CIS based thin film solar cell having high photoelectric conversion efficiency of 14% or more could be formed by controlling the film thickness of the In layer with low Na concentration and the film thickness of the In layer with high Na concentration. The Na concentration in the In target with low Na concentration was constant at 1 - 100 at.ppm (0.01 at.%). Therefore, the Na concentration in the target with low Na concentration should be 100 at.ppm or less.

### DESCRIPTION OF REFERENCE NUMERAL

- 1: non-alkali or low alkali glass substrate
- 2: metal backside electrode layer
- 3: p-type light absorbing layer
- 4: n-type high resistance buffer layer
- 5: n-type transparent and electrically conductive window layer
- 30a - 30f: metal precursor film
- 31: CuGa layer that contains Na
- 32: CuGa layer that does not contain Na
- 33: In layer
- 34: Cu layer
- 100: sputtering apparatus
- 102: CuGa target that contains Na
- 104: CuGa target that does not contain Na
- 106: In target
- 130a - 130f: metal precursor film
- 230a - 230f: metal precursor film

## Claims

1. A method for manufacturing a CIS-based thin film solar cell comprising:
forming a backside electrode layer on a substrate;
forming a p-type CIS-based light absorbing layer on the backside electrode layer; and
forming an n-type transparent and electrically conductive film on the p-type CIS-based light absorbing layer,
wherein said forming the p-type CIS-based light absorbing layer comprises: forming a metal precursor film at least comprising a first metal layer containing a I group element and a second metal layer containing a III group element; and selenizing and/or sulfurizing said metal precursor film, and
wherein said forming the metal precursor film includes forming either one of the first metal layer or second metal layer of at least two layers including a layer that contains an alkali metal and a layer that substantially does not contain the alkali metal.

2. The method according to claim 1, wherein the substrate is formed of any of high distortion point glass, non-alkali glass, metal or resin.

3. The method according to claim 2, wherein the first metal layer is formed of any of Cu and CuGa alloy and the second metal layer is formed of In.

4. The method according to claim 3, wherein, when the first metal layer is a CuGa alloy layer, the layer that contains the alkali metal is formed by using CuGa that contains at least 0.5 at.% of Na as a target or a deposition source.

5. The method according to claim 4, wherein a Ga concentration in the CuGa target is 10 - 50 at.%.

6. The CIS-based thin film solar cell according to claim 4, wherein the layer that substantially does not contain the alkali metal is formed by using CuGa that contains 100 at.ppm or less of Na as a target or a deposition source.

7. The CIS-based thin film solar cell according to claim 5, wherein the layer that substantially does not contain the alkali metal is formed by using CuGa that contains 100 at.ppm or less of Na as a target or a deposition source.

8. The method according to claim 1, wherein, when the first metal layer is a CuGa alloy layer, the layer that contains the alkali metal is formed using CuGa that contains the alkali metal as a first target or deposition source and the layer that substantially does not contain the alkali metal is formed using CuGa that substantially does not contain the alkali metal as a second target or deposition source and, in the first and second targets or deposition sources, a Ga concentration in the CuGa alloy is substantially constant.

9. The method according to claim 1, wherein, when the first metal layer is an In layer, the layer that contains the alkali metal is formed by using In that contains at least 0.2 at.% of Na as a target or a deposition source.

10. The CIS-based thin film solar cell according to claim 9, wherein the layer that does not contain the alkali metal is formed using In that contains 100 at.ppm or less of Na as a target or a deposition source.

11. The method according to claim 1, wherein the first metal layer and the second metal layer are formed by any of sputtering, vapor deposition or ion plating.

12. The method according to claim 1, wherein the alkali metal is any of Na, K or Li.

13. The method according to claim 1, further including forming an n-type high resistance buffer layer between said forming the p-type light absorbing layer and said forming the n-type transparent and electrically conductive film.

## Amended claims

### Amended claims under Art. 19.1 PCT

**1.** (Amended) A method for manufacturing a CIS-based thin film solar cell comprising:
forming a backside electrode layer on a substrate;
forming a p-type CIS-based light absorbing layer on the backside electrode layer; and
forming an n-type transparent and electrically conductive film on the p-type CIS-based light absorbing layer,
wherein said forming the p-type CIS-based light absorbing layer comprises: forming a metal precursor film by laminating at least a first metal layer containing a I group element and a second metal layer containing a III group element; and selenizing and/or sulfurizing the metal precursor film,
**characterized in that**, in said forming the metal precursor film, either one of the first metal layer or second metal layer is formed by independently performing a first forming step using the first or second metal layer material to which an alkali metal is added, and a second forming step using the material that substantially does not contain the alkali metal.

**2.** The method according to claim 1, wherein the substrate is formed of any of high distortion point glass, non-alkali glass, metal or resin.

**3.** The method according to claim 2, wherein the first metal layer is formed of any of Cu and CuGa alloy and the second metal layer is formed of In.

**4.** The method according to claim 3, wherein, when the first metal layer is a CuGa alloy layer, the layer that contains the alkali metal is formed by using CuGa that contains at least 0.5 at.% of Na as a target or a deposition source.

**5.** The method according to claim 4, wherein a Ga concentration in the CuGa target is 10 - 50 at.%.

**6.** (Amended) The method according to claim 4, wherein the layer that substantially does not contain the alkali metal is formed by using CuGa that contains 100 at.ppm or less of Na as a target or a deposition source.

**7.** (Amended) The method according to claim 5, wherein the layer that substantially does not contain the alkali metal is formed by using CuGa that contains 100 at.ppm or less of Na as a target or a deposition source.

**8.** The method according to claim 1, wherein, when the first metal layer is a CuGa alloy layer, the layer that contains the alkali metal is formed using CuGa that contains the alkali metal as a first target or deposition source and the layer that substantially does not contain the alkali metal is formed using CuGa that substantially does not contain the alkali metal as a second target or deposition source and, in the first and second targets or deposition sources, a Ga concentration in the CuGa alloy is substantially constant.

**9.** (Amended) The method according to claim 1, wherein, when the second metal layer is an In layer, the layer that contains the alkali metal is formed by using In that contains at least 0.2 at.% of Na as a target or a deposition source.

**10.** (Amended) The method according to claim 9, wherein the layer that does not contain the alkali metal is formed using In that contains 100 at.ppm or less of Na as a target or a deposition source.

**11.** The method according to claim 1, wherein the first metal layer and the second metal layer are formed by any of sputtering, vapor deposition or ion plating.

**12.** The method according to claim 1, wherein the alkali metal is any of Na, K or Li.

**13.** The method according to claim 1, further including forming an n-type high resistance buffer layer between said forming the p-type light absorbing layer and said forming the n-type transparent and electrically conductive film.
